# EUROPEAN PATENT APPLICATION

(11) **EP 3 457 202 A1**
(43) Date of publication of application: **20.03.2019**
(21) Application number: 18190838.5
(22) Date of filing: 24.08.2018
(51) Int. Cl.: G02F 1/1343, G02F 1/1337

(54) **LIQUID CRYSTAL DISPLAY DEVICE**

(30) Priority: 15.09.2017 KR 20170118939
(71) Applicant: Samsung Display Co., Ltd, Gyeonggi-do 17113 (KR)
(72) Inventor: BAE, Kwang Soo, Gyeonggi-Do (KR); BANG, Jung Suk, Gyeonggi-Do (KR); OH, Min Jeong, Gyeonggi-Do (KR); LEE, Bo Ram, Gyeonggi-do (KR); CHO, Young Je, Gyeonggi-do (KR)
(74) Representative: Taor, Simon Edward William

(57) **Abstract**

A liquid-crystal display (LCD) device includes a first substrate having pixels defined thereon, an insulating layer disposed on the first substrate, a pixel electrode disposed on the insulating layer in each of the pixels, an alignment layer disposed on the pixel electrode, a second substrate facing the first substrate, a wavelength conversion layer and a transmission layer disposed on the second substrate to face the first substrate, a common electrode disposed on the wavelength conversion layer and the transmission layer to face the first substrate, and a liquid-crystal layer interposed between the alignment layer and the common electrode. Each of the pixels includes an open area including at least one first side and that at least partially overlaps with the wavelength conversion layer and the transmission layer, and the insulating layer includes a pattern of grooves disposed adjacent to the at least one first side of the open area.

## Description

### BACKGROUND

### FIELD

Exemplary embodiments of the invention relate generally to a liquid-crystal display (LCD) device, and, more specifically, to an LCD device having improved light transmittance.

### DISCUSSION OF THE BACKGROUND

Display devices are becoming more important with the advancement of multimedia technology. Accordingly, various types of display devices, such as liquid-crystal display (LCD) devices and organic light-emitting display (OLED) devices are currently being used.

Among display devices, an LCD device may be one of the most broadly used flat panel display devices. An LCD device includes electric field generating electrodes, such as pixel electrodes and a common electrode, and displays an image by applying a voltage to the field generating electrodes to generate an electric field across a liquid-crystal layer, which may align liquid-crystal molecules in the liquid-crystal layer to control the polarization of incident light.

Among such LCD devices, a vertically-aligned (VA) mode LCD, which include liquid-crystal molecules having their major axes oriented perpendicular to the top and bottom panels when no electric field is applied, is attracting attention due to its large contrast ratio and its ease in achieving a wide viewing angle.

A liquid-crystal display device using a phosphor or a fluorescent substance that emits light of a specific wavelength band upon receiving light to display color has been recently researched. In general, display devices using a phosphor or a fluorescent substance have a wide viewing angle.

The above information disclosed in this Background section is only for understanding of the background of the inventive concepts, and, therefore, it may contain information that does not constitute prior art.

### SUMMARY

Applicant has recognized a need to improve transmittance in display devices with wide viewing angle and/or to improve the response speed of the liquid-crystal molecules.

Additional features of the inventive concepts will be set forth in the description which follows, and in part will be apparent from the description, or may be learned by practice of the inventive concepts.

It is to be understood that both the foregoing general description and the following detailed description are exemplary and explanatory and are intended to provide further explanation of the invention as claimed.

According to an exemplary embodiment of the invention, a liquid-crystal display (LCD) device includes a first substrate having a plurality of pixels defined thereon, an insulating layer disposed on the first substrate, a pixel electrode disposed on the insulating layer in each of the pixels, an alignment layer disposed on the pixel electrode, a second substrate facing the first substrate, a wavelength conversion layer and a transmission layer disposed on the second substrate to face the first substrate, a common electrode disposed on the wavelength conversion layer and the transmission layer to face the first substrate, and a liquid-crystal layer interposed between the alignment layer and the common electrode. Each of the pixels includes an open area including at least one first side and that at least partially overlaps with the wavelength conversion layer and the transmission layer, and the insulating layer includes a pattern of grooves disposed adjacent to the at least one first side of the open area.

The pixel electrode may include a planar electrode disposed adjacent to one of the grooves, and an edge electrode disposed adjacent to at least a second side of the open area, the edge electrode having a shape that substantially conforms to e at least the first side of the open area.

The planar electrode and the edge electrode may be spaced apart from each other by a slit therebetween, and the slit may have a shape substantially conforming to opposing sides of the planar electrode and the edge electrode.

A width of the slit may be substantially uniform over its length.

The first side of the open area may face the second side of the open area, and the planar electrode may be interposed between the first side and the second side of the open area.

The alignment layer may be orientated in a direction from one end of the first side of the open area toward one end of the second side of the open area.

The alignment layer may have a rubbed surface.

The groove may be formed on the first or second sides of the open area.

The edge electrode may be disposed adjacent to the second side of the open area.

The planar electrode may overlap with the open area.

The groove may be disposed on a top surface of the insulating layer and extends downwardly toward the first substrate.

The LCD device may further include a light-blocking element disposed on the second substrate to face the first substrate, in which the pattern of grooves may overlap the light-blocking element.

A width of the groove may be equal to or greater than 1 µm.

A depth of the groove may be equal to or greater than 1 µm.

The insulating layer may have a refractive index of 1.5 or less.

The wavelength conversion layer may include at least one of quantum dots and a phosphor material.

The LCD device may further include a second light-blocking element disposed on the alignment layer in an area not overlapping the open area.

A plurality of data lines may be disposed between the first substrate and the insulating layer, at least some of the data lines may be disposed between the open area and adjacent open area, in which a portion of at least one of the grooves may overlap the data line.

According to another exemplary embodiment of the invention, a liquid-crystal display (LCD) device includes a first substrate having a plurality of pixels each including an open area, an insulating layer disposed on the first substrate, a pixel electrode disposed on the insulating layer in each of the pixels, a second substrate facing the first substrate, a wavelength conversion layer and a transmission layer disposed on the second substrate to face the first substrate, a common electrode disposed on each of the wavelength conversion layer and the transmission layer to face the first substrate, and a liquid-crystal layer interposed between the pixel electrode and the common electrode. The pixel electrode includes a planar electrode having at least a first side and a second side, and an edge electrode disposed adjacent to the first side of the planar electrode, and the insulating layer includes a pattern of grooves disposed adjacent to the second side of the planar electrode.

The planar electrode may be disposed between the groove and the edge electrode.

According to still another exemplary embodiment of the invention, a liquid-crystal display (LCD) device includes a first substrate having a plurality of pixels each including an open area having opposed and connected sides, an insulating layer including a pattern of grooves and disposed on the first substrate, a pixel electrode disposed on the insulating layer in each of the pixels, a second substrate facing the first substrate, a common electrode disposed on the second substrate, and a liquid-crystal layer interposed between the pixel electrode and the common electrode. The pixel electrode includes a planar electrode and an edge electrode spaced apart from each other by a slit therebetween, at least one of the grooves of the insulating layer is disposed along two connected sides of the open area, the edge electrode is disposed along two opposing sides of the open area, and the planar electrode is disposed between the groove and the edge electrode.

According to an aspect of the invention, there is provided a liquid-crystal display device as set out in claim 1. Preferred features of this aspect are set out in claims 2 to 15.

It should be noted that effects of the disclosure are not limited to those described above and other effects of the disclosure will be apparent to those skilled in the art from the following descriptions.

### BRIEF DESCRIPTION OF THE DRAWINGS

The accompanying drawings, which are included to provide a further understanding of the invention and are incorporated in and constitute a part of this specification, illustrate exemplary embodiments of the invention, and together with the description serve to explain the inventive concepts.
FIG. 1 is a layout diagram of an exemplary embodiment of a pixel unit constructed according to the principles of the invention.
FIG. 2 is a cross-sectional view taken along line I - I' of FIG. 1.
FIG. 3 is an enlarged view of portion A of FIG. 2.
FIG. 4 is a graph illustrating transmittance measured over different areas of a first pixel according to an exemplary embodiment of the invention.
FIG. 5 is a cross-sectional view taken along line I - I' of FIG. 1 illustrating a pixel unit according to another exemplary embodiment of the invention.
FIG. 6 is a layout diagram showing a pixel unit according to yet another exemplary embodiment of the invention.
FIG. 7 is a cross-sectional view taken along line II - II' of FIG. 6.
FIG. 8 is a layout diagram showing a pixel unit according to still another exemplary embodiment of the invention.
FIG. 9 is a cross-sectional view taken along line III - III' of FIG. 8.
FIG. 10 is a layout diagram showing a pixel unit according to another exemplary embodiment of the invention.
FIG. 11 is a cross-sectional view taken along line IV - IV' of FIG. 10.
FIG. 12 is a cross-sectional view taken along line I - I' of FIG. 1 of a pixel unit according to another exemplary embodiment of the invention.

### DETAILED DESCRIPTION

In the following description, for the purposes of explanation, numerous specific details are set forth in order to provide a thorough understanding of various exemplary embodiments or implementations of the invention. As used herein "embodiments" and "implementations" are interchangeable words that are non-limiting examples of devices or methods employing one or more of the inventive concepts disclosed herein. It is apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an exemplary embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the D1-axis, the D2-axis, and the D3-axis are not limited to three axes of a rectangular coordinate system, such as the x, y, and z - axes, and may be interpreted in a broader sense. For example, the D1-axis, the D2-axis, and the D3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

Unless otherwise defined, all terms (including technical and scientific terms) used herein have the same meaning as commonly understood by one of ordinary skill in the art to which this disclosure is a part. Terms, such as those defined in commonly used dictionaries, should be interpreted as having a meaning that is consistent with their meaning in the context of the relevant art and should not be interpreted in an idealized or overly formal sense, unless expressly so defined herein.

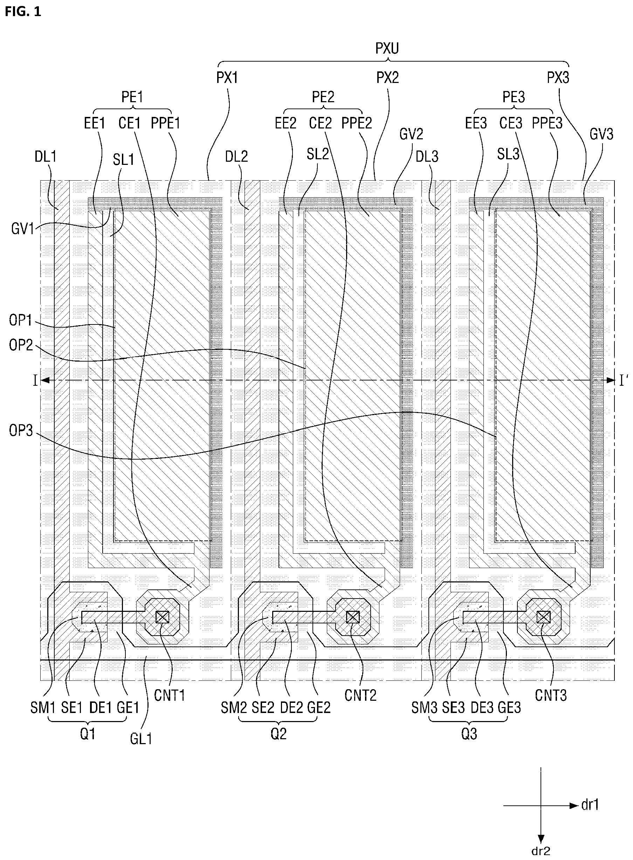

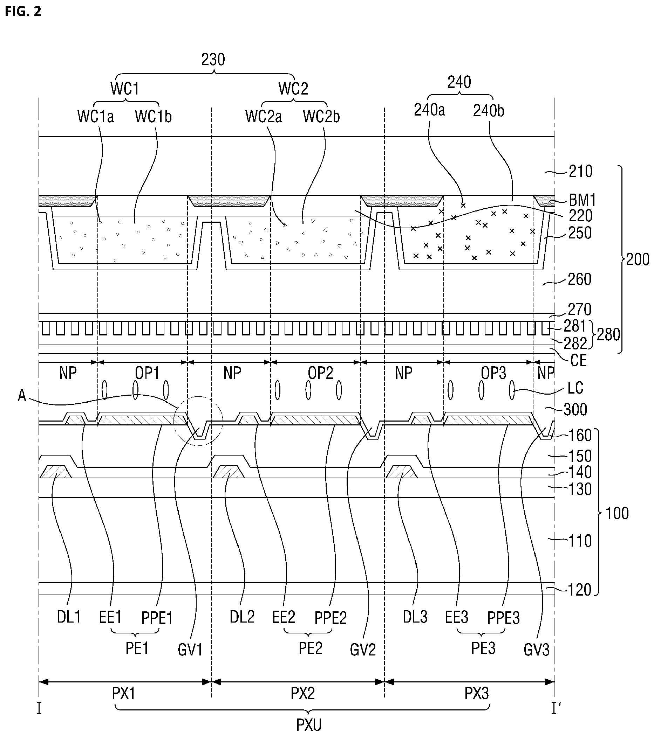

FIG. 1 is a layout diagram showing an exemplary embodiment of a pixel unit constructed according to the principles of the invention. FIG. 2 is a cross-sectional view taken along line I - I' of FIG. 1.

Referring to FIGS. 1 and 2, a display device according to an exemplary embodiment of the invention includes a bottom panel 100, a top panel 200, and a liquid-crystal layer 300. The bottom panel 100 and the top panel 200 include a lower substrate 110 and an upper substrate 210, respectively.

As used herein, the "upper side" of the lower substrate 110 refers to a side facing an upper substrate 210, and the "lower side" of the lower substrate 110 refers to the opposite side. In addition, the "upper side" of the upper substrate 210 refers to a side facing away from the lower substrate 110, and the "lower side" of the upper substrate 210 refers to the opposite side facing toward the lower substrate 110.

The bottom panel 100 and the top panel 200 may face each other. The liquid-crystal layer 300 may be interposed between the bottom panel 100 and the top panel 200, and may include liquid-crystal molecules LC. In an exemplary embodiment, the bottom panel 100 and the top panel 200 may be attached together by a sealant.

A liquid-crystal display device includes a plurality of pixel units PXU arranged in a matrix form. The pixel units PXU may be disposed on the lower substrate 110. Each of the pixel units PXU may include a first pixel PX1, a second pixel PX2, and a third pixel PX3. In an exemplary embodiment, the first pixel PX1, the second pixel PX2, and the third pixel PX3 may display different colors. The grayscale of each of the first pixel PX1, the second pixel PX2, and the third pixel PX3 may be controlled individually, and each pixel may be a unit for reproducing a particular color. The pixel unit PXU may control the transmittance of each of the first pixel PX1, the second pixel PX2, and the third pixel PX3, and may combine the colors from the pixels to produce a desired color. The pixels of the pixel unit PXU are arranged in parallel in the first direction dr1 in the exemplary embodiment illustrated in FIGS. 1 and 2. However, embodiments of the invention are not limited thereto, and the pixels may be arranged adjacent to one another in a different way. In addition, although the pixel unit PXU shown in FIG. 1 illustrates the first pixel PX1, the second pixel PX2, and the third pixel PX3, the number of the pixels in the pixel unit PXU may be varied as desired.

Hereinafter, the bottom panel 100 will be described.

The lower substrate 110 according to an exemplary embodiment may be a transparent insulation substrate. The transparent insulation substrate may include a glass substrate, a quartz substrate, a transparent resin substrate, etc.

A first polarizing layer 120 may be disposed under the lower substrate 110. More specifically, the lower substrate 110 may have an upper surface facing the upper substrate 210 and a lower surface opposite to the upper surface. The first polarizing layer 120 according to an exemplary embodiment may be disposed on the lower surface of the lower substrate 110. The first polarizing layer 120 may include an organic material or an inorganic material. In an exemplary embodiment, the first polarizing layer 120 may be a reflective polarizing layer, which may transmit polarization components in a direction substantially parallel to a transmission axis, while reflecting polarization components in a direction substantially parallel to a reflection axis.

The first polarizing layer 120 may alternatively be disposed on the upper surface of the lower substrate 110, such that the first polarizing layer 120 is disposed between the lower substrate 110 and a first insulating layer 130 to be described below.

On the lower substrate 110, a first gate line GL1 and first to third gate electrodes GE1 to GE3 are disposed. The first gate line GL1 may deliver a gate voltage for controlling a thin-film transistor. The first gate line GL1 may substantially extend in a first direction dr1.

As used herein, the first direction dr1 may be an arbitrary direction on a plane on which the lower substrate 110 is disposed. The first direction dr1 may be substantially perpendicular to a second direction dr2 described later.

The gate voltage may be applied from an external source, and may have a variable voltage level. The thin-film transistor may be turned on/off in response to the voltage level of the gate voltage.

The first to third gate electrodes GE1 to GE3 may protrude from the first gate line GL1, and may be physically connected to the first gate line GL1. The first to third gate electrodes GE1 to GE3 may be an element of the first to third thin-film transistors Q1 to Q3, respectively, which will be described later.

The first gate line GL1 and the first to third gate electrodes GE1 to GE3 may include the same material. For example, the first gate line GL1 and the first to third gate electrodes GE1 to GE3 may include: an aluminum-based metal, such as aluminum (Al) and an aluminum alloy; a silver-based metal, such as silver (Ag) and a silver alloy; a gold-based metal, such as copper (Cu) and a copper alloy; a molybdenum-based metal, such as molybdenum (Mo) and a molybdenum alloy; chrome (Cr); tantalum (Ta); and titanium (Ti). The gate line GL1 and the first to third gate electrodes GE1 to GE3 may have a single layer structure. Alternatively, the gate line GL1 and the first to third gate electrodes GE1 to GE3 may have a multi-layer structure including at least two conductive layers having different physical properties.

A first insulating layer 130 may be disposed on the first gate line GL1 and the first to third gate electrodes GE1 to GE3. The first insulating layer 130 may include an insulative material, for example, silicon nitride or silicon oxide. The first insulating layer 130 may have a single layer structure or a multi-layer structure including two insulating layers having different physical properties.

The first to third semiconductor layers SM1 to SM3 are disposed on the first insulating layer 130. The first to third semiconductor layers SM1 to SM3 may at least partially overlap with the first to third gate electrodes GE1 to GE3, respectively. The first to third semiconductor layers SM1 to SM3 may include at least one of amorphous silicon, polycrystalline silicon, and an oxide semiconductor. As used herein, the phrase "two elements overlap with each other" refers to two elements that overlap with other in a vertical direction with respect to the lower substrate 110.

An ohmic contact element may be optionally disposed adjacent to or in some area of each of the first to third semiconductor layers SM1 to SM3. For example, the ohmic contact element may include silicide or n+ hydrogenated amorphous silicon that is highly doped with n-type impurities. When the first to third semiconductor layers SM1 to SM3 include an oxide semiconductor, the ohmic contact element may be omitted.

First to third data lines DL1 to DL3, first to third source electrodes SE1 to SE3, and first to third drain electrodes DL1 to DL3 are disposed on the first to third semiconductor layers SM1 to SM3 and the first insulating layer 130, respectively.

The first to third data lines DL1 to DL3 may substantially extend in the second direction dr2 and may intersect with the first gate line GL1. The first to third data lines DL1 to DL3 may be insulated from the first gate line GL1 and the first to third gate electrodes GE1 to GE3 by the first insulating layer 130.

The first to third data lines DL1 to DL3 may provide a data voltage to the first to third source electrodes SE1 to SE3, respectively. The data voltage may be applied from an external source and may have a variable voltage level. As such, the grayscale of each of the first to third pixels PX1 to PX3 may be changed in response to the voltage level of the data voltages.

The first to third source electrodes SE1 to SE3 may branch off from the first to third data lines DL1 to DL3, respectively, and at least partially overlap with the first to third gate electrodes GE1 to GE3, respectively.

As shown in FIG. 1, the first to third drain electrodes DEI to DE3 may be spaced apart from the first to third source electrodes SE1 to SE3, respectively, with the first to third semiconductor layers SM1 to SM3 disposed therebetween, and at least partially overlap with the first to third gate electrodes GE1 to GE3, respectively.

In addition, the first to third source electrodes SE1 to SE3 may have a "C" shape and surround the first to third drain electrodes DE1 to DE3, respectively, with a predetermined spacing. However, embodiments of the invention are not limited thereto, and the first to third source electrodes SE1 to SE3 may have various shapes, such as a straight bar.

The first to third data lines DL1 to DL3, the first to third source electrodes SE1 to SE3, and the first to third drain electrodes DEI to DE3 may include the same material. For example, the first to third data lines DL1 to DL3, the first to third source electrodes SE1 to SE3, and the first to third drain electrodes DEI to DE3 may include aluminum, copper, silver, molybdenum, chromium, titanium, tantalum, or an alloy thereof, and may have a multi-layer structure. For example, the multi-layer structure may be a lower layer including a refractory metal and a low-resistance upper layer disposed on the lower layer.

The first gate electrode GE1, the first semiconductor layer SM1, the first source electrode SE1, and the first drain electrode DEI may form a first thin-film transistor Q1. The first thin-film transistor Q1 may be a switching element for controlling the first pixel PX1. The second gate electrode GE2, the second semiconductor layer SM2, the second source electrode SE2, and the second drain electrode DE2 may form a second thin-film transistor Q2. The second thin-film transistor Q2 may be a switching element for controlling the second pixel PX2. The third gate electrode GE3, the third semiconductor layer SM3, the third source electrode SE3, and the third drain electrode DE3 may form a third thin-film transistor Q3. The third thin-film transistor Q3 may be a switching element for controlling the third pixel PX3.

A passivation layer 140 is disposed on the first insulating layer 130 and the thin-film transistors. The passivation layer 140 may include an inorganic insulating material and may cover the thin-film transistors. The passivation layer 140 may protect the thin-film transistors by preventing the material forming a second insulating layer 150, which will be described later, from flowing into the semiconductor layers of the thin-film transistors.

The second insulating layer 150 is disposed on the passivation layer 140. The second insulating layer 150 may include an insulating material, such as an organic layer including an organic material. The second insulating layer 150 may be a planarization layer that flattens differences caused by the elements disposed thereunder to provide a substantially flat top surface.

However, the top surface of the second insulating layer 150 may not be entirely flat, and may include a pattern of grooves for controlling the liquid-crystal molecules LC. More specifically, the second insulating layer 150 may include a pattern of first to third grooves GV1 to GV3. The first groove GV1 may be formed in the first pixel PX1, the second groove GV2 may be formed in the second pixel PX2, and the third groove GV3 may be formed in the third pixel PX3. Each of the first to third grooves GV1 to GV3 may be extending downwardly from the top surface of the second insulating layer 150 towards the lower substrate 110.

The first to third grooves GV1 to GV3 may be patterned simultaneously during a mask process of forming first to third contact holes CNT1 to CNT3, which will be described later. For example, the first to third grooves GV1 to GV3 may be formed by using a halftone mask during the mask process of forming the first to third contact holes CNT1 to CNT3. However, embodiments of the invention are not limited thereto, and each of the first to third grooves GV1 to GV3 may be formed during a separate mask process conducted before or after forming the first to third contact holes CNT1 to CNT3.

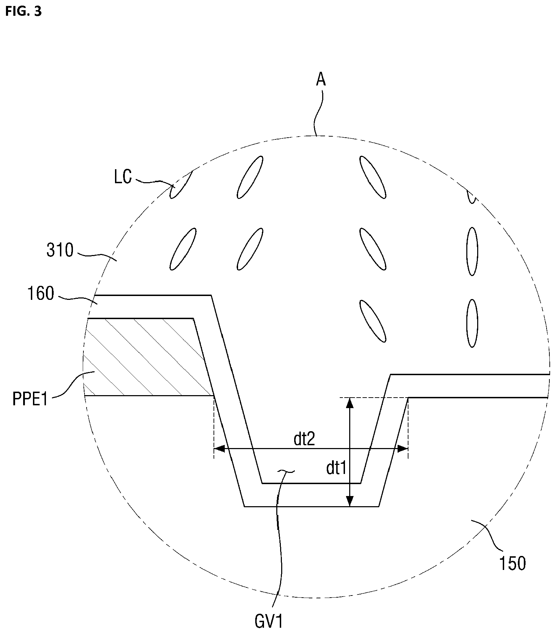

The structure of the pattern of first to third grooves GV1 to GV3 is closely related to the shape of first to third pixel electrodes PE1 to PE3, and thus, the detailed description of the first to third grooves GV1 to GV3 will be described below with reference to FIG. 3.

The second insulating layer 150 may include an organic material having a low refractive index. More specifically, the first to third pixel electrodes PE1 to PE3 may have a refractive index of approximately 1.5 to 1.7. On the other hand, the second insulating layer 150 includes an organic material having a low refractive index of 1.5 or less, such that the range of angles at which the total reflection occurs at the interface between the first to third pixel electrodes PE1 to PE3 and the second insulating layer 150 may be increased. In this manner, when light is scattered in a first wavelength conversion layer WC1, a second wavelength conversion layer WC2, and a transmission layer 240, and travels toward the second insulating layer 150, it is possible to increase the ratio of light that is totally reflected off the top surface of the second insulating layer 150 to travel back to the first wavelength conversion layer WC1, the second wavelength conversion layer WC2, and the transmission layer 240, as will be described in more detail later.

First to third contact holes CNT1 to CNT3 may be formed in the passivation layer 140 and the second insulating layer 150, through which a part of the first to third thin-film transistors Q1 to Q3, more specifically, a part of the first to third drain electrodes DEI to DE3 is exposed in the direction perpendicular to the top surface of the lower substrate 110 (or in plan view). The first to third contact holes CNT1 to CNT3 may be formed by penetrating the passivation layer 140 and the second insulating layer 150 in the direction perpendicular to the lower substrate 110. The part of the first to third pixel electrodes PE1 to PE3 disposed on the second insulating layer 150 may be connected to the first to third drain electrodes DEI to DE3 via the first to third contact holes CNT1 to CNT3, respectively.

In some exemplary embodiments, a portion of the passivation layer 140 and the second insulating layer 150 may be omitted or replaced with another layer. For example, a single layer may have all of the features and functionality of the passivation layer 140 and the second insulating layer 150.

On the second insulating layer 150, the first to third pixel electrodes PE1 to PE3 are disposed. The first pixel electrode PE1 is physically connected to the first drain electrode DEI through the first contact hole CNT1, and may receive the data voltage from the first drain electrode DEI. The first pixel electrode PE1 is physically connected to the first drain electrode DEI through the first contact hole CNT1, and may receive the data voltage from the second drain electrode DE2. The third pixel electrode PE3 is physically connected to the third drain electrode DE3 through the third contact hole CNT3, and may receive the data voltage from the third drain electrode DE3.

The first to third pixel electrodes PE1 to PE3 may include a transparent conductive material, such as indium tin oxide (ITO), indium zinc oxide (IZO), indium tin zinc oxide (ITZO), and Al-doped zinc oxide (AZO).

Hereinafter, a layout of the first to third pixel electrodes PE1 to PE3 when viewed from the top (plan view) will be described. The first pixel electrode PE1 disposed in the first pixel PX1 will be described as an example. The second pixel electrode PE2 disposed in the second pixel PX2 and the third pixel electrode PE3 disposed in the third pixel PX3 may have substantially the same configuration as that in the first pixel electrode PE1, and therefore, repeated description thereof will be omitted to avoid redundancy.

The first pixel electrode PE1 may have a larger area than a first open area OP1 overlapping the first pixel electrode PE1. The first open area OP1 corresponds to one of the plurality of openings formed in a first light-blocking element BM1, which will be described later, and corresponds to an opening formed in the first pixel PX1. Since the first open area OP1 allows light to pass therethrough, a viewer can see the light provided through the first open area OP1.

Although the first open area OP1 is described as an area corresponding to one of the plurality of openings formed in the first light-blocking element BM1, embodiments of the invention are not limited thereto. For example, when a metal layer for signal transmission blocks light, it may be possible to block light without forming a separate light-blocking element overlapping the metal layer. In such case, the first open area OP1 may correspond to the area formed with the light-blocking element (see FIG. 2) in addition to the areas other than an area not covered by the metal layer.

The first pixel electrode PE1 includes a first planar electrode PPE1, a first edge electrode EE1, and a first connecting electrode CE1. The first planar electrode PPE1 occupies most of the area of the first pixel electrode PE1, and may be formed on a plane with no additional opening. The first planar electrode PPE1 may be disposed to overlap with the first open area OP1. The first planar electrode PPE1 may be electrically connected to the first connecting electrode CE1 to receive the data voltage.

The first edge electrode EE1 may be disposed adjacent to at least one side of the first open area OP1, and may be electrically connected to the first planar electrode PPE1 or the first connecting electrode CE1 to receive the data voltage. The first edge electrode EE1 may be disposed along at least one side of the first open area OP1 and another side connected to the one side. As shown in FIG. 1, the first edge electrode EE1 according to an exemplary embodiment is disposed adjacent to the left side and the lower side of the first open area OP1.

A transparent conductive material may not be disposed between the first edge electrode EE1 and the first planar electrode PPE1, and a first slit SL1 reflecting the shape of the first edge electrode EE1 may be formed between the first edge electrode EE1 and the first planar electrode PPE1.

The outer sides of the first edge electrode EE1 may be disposed adjacent to one side of the first open area OP1 when viewed from the top. For example, the boundary line defined by the outer sides of the first edge electrode EE1 may be disposed outside of the boundary line of the first open area OP1. As used herein, the outer sides of the first edge electrode EE1 refer to the sides opposite to a side adjacent to the first planar electrode PPE1. For example, in FIG. 1, the outer sides of the first edge electrode EE1 are the left side and the lower side of the first edge electrode EE1.

The first edge electrode EE1 may strengthen the force by which the liquid-crystal molecules LC are tilted in a particular direction. More specifically, when the data voltage is applied to the first pixel electrode PE1 and the first edge electrode EE1, the liquid-crystal molecules LC are tilted in a direction along the direction of the electric field formed by the data voltage. In this case, the intensity of the electric field directed toward the center of the first planar electrode PPE1 may be greater in the outer sides of the first planar electrode PPE1 that are closer to the first edge electrode EE1. Accordingly, the liquid-crystal molecules LC overlapping with the first planar electrode PPE1 may be tilted in the direction from the first edge electrode EE1 toward the first planar electrode PPE1. Further, the liquid-crystal molecules LC overlapping with the first edge electrode EE1 and the first slit SL1 may also be tilted in the direction from the first edge electrode EE1 toward the first planar electrode PPE1.

The location of the first edge electrode EE1 may be determined in consideration of the alignment direction of an alignment layer 160, which will be described later. More specifically, the first edge electrode EE1 may be disposed at a location where the alignment direction of the alignment layer 160 starts. According to an exemplary embodiment, the alignment direction of the alignment layer 160 is diagonally from the lower left end to the upper right end of FIG. 1. Accordingly, the first edge electrode EE1 is disposed adjacent to the outer sides at the lower left end of the first planar electrode PPE1 (e.g., the left side and the lower side of the first planar electrode PPE1).

The alignment layer 160 may include a rubbed surface. The alignment direction of the alignment layer 160 may also be a factor that determines which direction the liquid-crystal molecules LC tilt. Accordingly, when the liquid-crystal molecules LC are tilted by the alignment direction of the alignment layer 160 in the same direction as which the liquid-crystal molecules LC are tilted by the first edge electrodes EE1, the liquid-crystal molecules LC may be more effectively controlled by the first pixel electrode PE1, which may also improve the response speed of the liquid-crystal molecules LC.

The first connecting electrode CE1 may be electrically connected to the first drain electrode DEI through the first contact hole CNT1, and may deliver the data voltage received from the first drain electrode DEI to the first planar electrode PPE1 and the first edge electrode EE1. The first connecting electrode CE1 may not overlap with the first open area OP1.

The first to third grooves GV1 to GV3 may be formed adjacent to at least one side of the first to third open areas OP1 to OP3, respectively. Hereinafter, the first groove GV1 will be described as an example. The first groove GV1 may be disposed along two connected sides of the first open area OP1. According to an exemplary embodiment, the first groove GV1 is disposed adjacent to the right side and the upper side of the first open area OP1, as shown in FIG. 1.

The first groove GV1 may not overlap with the first pixel electrode PE1 including the first planar electrode PPE1 and the first edge electrode EE1. More particularly, the first pixel electrode PE1 may be disposed only in the flat portion of the top surface of the second insulating layer 150.

In addition, the first groove GV1 may be formed on the side opposite to the side on which the first edge electrode EE1 is disposed, with the first planar electrode PPE1 interposed therebetween. For example, when the first edge electrode EE1 is disposed adjacent to the left side and the lower side of the first open area OP1, the first groove GV1 may be formed adjacent to the right side and the upper side of the first open area OP1, as shown in FIG. 1.

The location at which the first groove GV1 is disposed may be determined in consideration of the alignment direction of the alignment layer 160 to be described later. More particularly, the first groove GV1 is formed adjacent to at least one side of the first open area OP1 corresponding to the alignment direction of the alignment layer 160. For example, the alignment direction of the alignment layer 160 is diagonally from the lower left end to the upper right end of FIG. 1. Accordingly, the first groove GV1 is formed adjacent to the outer sides at the upper right end of the first open area OP1 (e.g., the upper side and the right side of the first open area OP1).

As described above, the alignment direction of the alignment layer 160 and the location of the first edge electrode EE1 may be factors that determine the direction to which the liquid-crystal molecules LC are tilted. The liquid-crystal molecules LC according to an exemplary embodiment are tilted toward the upper right end of FIG. 1 according to the alignment direction of the alignment layer 160 and the location of the first edge electrode EE1. Likewise, the first groove GV1 may control the liquid-crystal molecules LC in the first open area OP1 so that the liquid-crystal molecules LC are tilted toward the first groove GV1. In particular, the liquid-crystal molecules LC in the first open area OP1 may be controlled, so that they are tilted toward the upper right end of FIG. 1, depending on the location of the first groove GV1, the alignment direction of the alignment layer 160, and the location of the first edge electrode EE1. Accordingly, the liquid-crystal molecules LC may be controlled more effectively by the first pixel PX1, which may increase light transmittance. Further, the response time of the liquid-crystal molecules LC in the first pixel PX1 may be improved.

More detailed descriptions thereof will be given with reference to FIG. 3. FIG. 3 is an enlarged view of portion A of FIG. 2.

Referring to FIG. 3, the first groove GV1 having a pair of sloped side walls may be formed in the second insulating layer 150. More specifically, the first groove GV1 may provide the second insulating layer 150 with a groove having a pair of sidewalls having a forward slope with respect to one surface of the lower substrate 110. One of the sloped side walls of the groove may be formed adjacent to the first planar electrode PPE1. By virtue of the geometry of the first groove GV1, the liquid-crystal molecules LC may receive a force by which they are tilted toward the first groove GV1. Thus, the liquid-crystal molecules LC overlapping with the first planar electrode PPE1 may be tilted toward first groove GV1. This may be the same direction as the direction to which the liquid-crystal molecules LC are tilted depending on the location of the first edge electrode EE1 and the alignment direction of the alignment layer 160 described above. Accordingly, the liquid-crystal molecules LC overlapping with the first planar electrode PPE1 are uniformly tilted in one direction, which may reduce the collision between the liquid-crystal molecules LC, and thereby improving light transmittance.

The liquid-crystal molecules LC disposed on a side of the first groove pattern GV1, which is opposite to the first planar electrodes PPE1, may receive a force by which they are tilted toward the first groove pattern GV1. However, because the opposite side overlaps the first light-blocking element BM1 that blocks light, and is a region that does not overlap the first open area OP1, the light transmittance may not be affected.

The depth dt1 of the first groove GV1 may be 1 µm or more. The first groove GV1 can effectively control the direction to which the liquid-crystal molecules LC are tilted when the depth dt1 of the first groove pattern GV1 is 1 µm or more. For example, when the depth dt1 of the first groove pattern GV1 is less than 1 µm, the liquid-crystal molecules LC may not receive a sufficient force by which they are tilted toward the first groove GV1.

The width dt2 of the first groove GV1 may be 1 µm or more. The first groove GV1 can effectively control the direction to which the liquid-crystal molecules LC are tilted when the width dt2 of the first groove pattern GV1 is 1 µm or more. For example, when the width dt1 of the first groove pattern GV1 is less than 1 µm, the liquid-crystal molecules LC may not receive a sufficient force by which they are tilted toward the first groove GV1.

Referring back to FIGS. 1 and 2, the description of the first pixel electrode PE1 may be equally applied to the second pixel electrode PE2 and the third pixel electrode PE3. In addition, the description of the first planar electrode PPE1 may be applied equally to the second planar electrode PPE2 and the third planar electrode PPE3, the description of the first edge electrode EE1 may be equally applicable to the second edge electrode EE2 and the third edge electrode EE3, the description of the first connecting electrode CE1 may be equally applied to the second connecting electrode CE2 and the third connecting electrode CE3, and the description of the first open area OP1 may be equally applied to the second open area OP2 and the third open area OP3. Furthermore, the description of the first groove GV1 may be equally applied to the second groove GV2 and the third groove GV3.

The alignment layer 160 is disposed on the first to third pixel electrodes PE1 to PE3. The alignment layer 160 may control the alignment direction and the initial orientation angle of the liquid-crystal molecules LC. The alignment layer 160 may include an alignment material. The alignment material may be an organic polymer material. The organic polymer material may include at least one of polyimide, polyamic acid, and polysiloxane, for example.

The alignment layer 160 may have grooves on its top surface that extend along the alignment direction. As used herein, the alignment direction refers to a direction to which the liquid-crystal molecules LC are tilted, and may be the same as the direction to which the alignment material applied at the time of forming the alignment layer 160 is scraped off via a rubbing process. According to the illustrated exemplary embodiment, the alignment direction may extend diagonally from the lower left end toward the upper right end of FIG. 1.

Next, the top panel 200 will be described.

The upper substrate 210 may face the lower substrate 110. The upper substrate 210 may include transparent glass, plastic, etc. According to an exemplary embodiment, the upper substrate 210 may include the same material as the lower substrate 110.

The first light-blocking element BM1 may be disposed on the lower surface of the upper substrate 210 facing the lower substrate 110. In FIG. 1, the open area where the first light-blocking element BM1 is not disposed may correspond to one of the first to third open areas OP1 to OP3, and the area where the first light-blocking element BM1 is disposed may correspond to a light-blocking area NP. The first light-blocking element BM may block the transmission of light outside the first to third open areas OP1 to OP3. In particular, the regions where the first to third pixels PX1 to PX3 are disposed may be divided into the first to third open areas OP1 to OP3 and the light-blocking area NP, in terms of the first light-blocking element BM1. In some exemplary embodiments, however, the first light-blocking element BM1 may further include an opening in an area other than the areas overlapping the first to third pixel electrodes PE1 to PE3. For example, the first light-blocking element BM1 may further include an opening in the areas where the first to third thin-film transistors Q1 to Q3 are disposed, etc.

The first light-blocking element BM1 may include a material that blocks light. In an exemplary embodiment, the first light-blocking element BM1 may include an organic material or a metallic material including chrome. Although FIG. 2 shows the light-blocking element BM disposed on the top panel 200, embodiments of the invention are not limited thereto. For example, the first light-blocking element BM1 may be disposed in the bottom panel 100. Furthermore, if another element blocks light, the light-blocking element BM may be omitted.

A first filter 220 and a transmission layer 240 are disposed on the lower surface of the first light-blocking element BM1 facing the lower substrate 110. The first filter 220 may overlap with the first wavelength conversion layer WC1 and the second wavelength conversion layer WC2.

The first filter 220 may block light having the first wavelength range, and may transmit the light having the second wavelength range and the light having the third wavelength range. The first filter 220 will be described in more detail with respect to the first wavelength conversion layer WC1. The light having the first wavelength range supplied to the first wavelength conversion layer WC1 is converted into the light having the second wavelength range by first wavelength-converting material WC1a. However, some of the light having the first wavelength range supplied to the first wavelength conversion layer WC1 may not contact the first wavelength-converting material WC1a. In this case, the light of the first wavelength range may be mixed with the light of the second wavelength range converted by the first wavelength-converting material WCla, thereby resulting in color mixing. As such, the first filter 220 blocks the light still having the first wavelength range even after having passed through the first wavelength conversion layer WC1, thereby preventing color mixing and improving color purity.

The first to third wavelength ranges may be different from one another. In an exemplary embodiment, the first wavelength range may have a central wavelength from approximately 420 nm to 480 nm. Accordingly, the light having the first wavelength range may be blue light. In an exemplary embodiment, the second wavelength range may have a central wavelength from approximately 600 nm to 670 nm. Accordingly, the light having the second wavelength range may be red light. In an exemplary embodiment, the third wavelength range may have a central wavelength from approximately 500 nm to 570 nm. Accordingly, the light having the third wavelength range may be green light.

In the following description, the light having the first wavelength range will be described as blue light, the light having the second wavelength range as red light, and the light having the third wavelength range as green light. Accordingly, the first filter 220 may block blue light and transmit red light and green light. More particularly, the first filter 220 may be a blue cut-off filter. The first filter 220 may have a single or multiple film structure.

The transmission layer 240 may be disposed to overlap with the third pixel PX3. The transmission layer 240 may include a third light-transmitting resin 240b and light-scattering material 240a.

The light-scattering material 240a may be dispersed in the third light-transmitting resin 240b to scatter light supplied to the transmission layer 240 so that the light may exit to the outside. The exiting light may be scattered in various directions regardless of the incident angle, and may be un-polarized light. As used herein, un-polarized light refers to light that does not include only polarization components in a particular direction, but that also includes random polarization components not polarized in a particular direction. For example, the un-polarized light may be natural light.

A color conversion layer 230 is disposed on the surface of the first filter facing the lower substrate 110. The color conversion layer 230 may include the first wavelength conversion layer WC1 and the second wavelength conversion layer WC2.

The first wavelength conversion layer WC1 may overlap with the first pixel PX1. In an exemplary embodiment, the first wavelength conversion layer WC1 may include a first light-transmitting resin WClb and first wavelength-converting material WC1a.

The first wavelength-converting material WC1a may be dispersed in the first light-transmitting resin WClb to convert or shift the light supplied to the first wavelength conversion layer WC1 into the light having the second wavelength range. The light supplied to the first wavelength conversion layer WC1 may be the light having the first wavelength range, for example, blue light. Accordingly, the first wavelength conversion layer WC1 may receive blue light from the outside and convert it into red light.

In an exemplary embodiment, the first wavelength-converting material WC1a may include first quantum dots. The particle size of the first quantum dots is not particularly limited as long as the first wavelength-converting material WC1a can convert the light received from the outside into the light of the second wavelength range. The first wavelength-converting material WC1a may be dispersed and naturally coordinated in the first light-transmitting resin WClb. The first light-transmitting resin WClb is not particularly limited as long as it is a transparent medium that does not affect the wavelength conversion of the first wavelength-converting material WC1a and does not absorb light.

For example, the first light-transmitting resin WClb may include epoxy, polystyrene, and acrylate. However, embodiments of the invention are not limited thereto, and the first light-transmitting resin WClb may include an organic solvent or may only include an organic solvent. In an exemplary embodiment, the organic solvent may include toluene, chloroform, and ethanol.

The second wavelength conversion layer WC2 may overlap with the second pixel PX2. In an exemplary embodiment, the second wavelength conversion layer WC2 may include a second light-transmitting resin WC2b and second wavelength-converting material WC2a.

The second wavelength-converting material WC2a may be dispersed in the second light-transmitting resin WC2b to convert or shift the light supplied to the second wavelength conversion layer WC2 into the light having the third wavelength range. The light supplied to the second wavelength conversion layer WC2 may be blue light, and accordingly, the second wavelength conversion layer WC2 may receive blue light from the outside and convert it into green light.

In an exemplary embodiment, the second wavelength-converting material WC2a may include second quantum dots. The particle size of the second quantum dots is not particularly limited as long as the second wavelength-converting material WC2a can convert the light received from the outside into the light of the third wavelength range. More particularly, the average particle size of the second wavelength-converting material WC2a may be less than the average particle size of the first wavelength-converting material WC1a.

The second wavelength-converting material WC2a may be dispersed and naturally coordinated in the second light-transmitting resin WC2b. The second light-transmitting resin WC2b is not particularly limited as long as it is a transparent medium that does not affect the wavelength conversion performance of the second wavelength-converting material WC2a and does not absorb light.

For example, the second light-transmitting resin WC2b may include epoxy, polystyrene, and acrylate. However, embodiments of the invention are not limited thereto, and the second light-transmitting resin WC2b may include an organic solvent or may include only an organic solvent. In an exemplary embodiment, the organic solvent may include toluene, chloroform, and ethanol.

The first quantum dots and the second quantum dots may be selected from group II - VI compounds, group III - V compounds, group IV - VI compounds, group IV elements, group IV compounds, and a combination thereof.

The group II - VI compounds may be selected from the group consisting of: binary compounds selected from the group consisting of CdSe, CdTe, ZnS, ZnSe, ZnTe, ZnO, HgS, HgSe, HgTe, MgSe, MgS, and a mixture thereof; ternary compounds selected from the group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a mixture thereof; and quaternary compounds selected from the group consisting of HgZnTeS, CdZnSeS, CdZnSeTe, CdZnSTe, CdHgSeS, CdHgSeTe, CdHgSTe, HgZnSeS, HgZnSeTe, HgZnSTe, and a mixture thereof.

The group III - V compounds may be selected from the group consisting of: binary compounds selected from the group consisting of GaN, GaP, GaAs, GaSb, AlN, AlP, AlAs, AlSb, InN, InP, InAs, InSb, and a mixture thereof; ternary compounds selected from the group consisting of GaNP, GaNAs, GaNSb, GaPAs, GaPSb, AlNP, AINAs, AINSb, AlPAs, AlPSb, InNP, InNAs, InNSb, InPAs, InPSb, GaAlNP, and a mixture thereof; and quaternary compounds selected from the group consisting of GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and a mixture thereof.

The group IV - VI compounds may be selected from the group consisting of: binary compounds selected from the group consisting of SnS, SnSe, SnTe, PbS, PbSe, PbTe, and a mixture thereof; ternary compounds selected from the group consisting of SnSeS, SnSeTe, SnSTe, PbSeS, PbSeTe, PbSTe, SnPbS, SnPbSe, SnPbTe, and a mixture thereof; and quaternary compounds selected from the group consisting of SnPbSSe, SnPbSeTe, SnPbSTe, and a mixture thereof. The group IV elements may be selected from the group consisting of Si, Ge, and a mixture thereof. The group IV compounds may be binary compounds selected from the group consisting of SiC, SiGe, and a mixture thereof.

The binary compounds, the ternary compounds, or the quaternary compounds may be present in the particles at a substantially uniform concentration, or may be present in the same particles at partially different concentrations. In addition, they may have a core/shell structure in which one quantum dot surrounds another quantum dot. At the interface between the core and the shell, the gradient of the concentration of atoms in the shell may be decreased toward the center.

The first quantum dots and the second quantum dots may have a full width of half maximum (FWHM) of the emission wavelength spectrum of approximately 45 nm or less, preferably approximately 40 nm or less, more preferably approximately 30 nm or less. Within this range, color purity and color gamut may be improved. Also, light emitted through the first quantum dots and the second quantum dots is emitted in all directions, so that the viewing angle may be improved.

In addition, in an exemplary embodiment, the first quantum dots and the second quantum dots may have a spherical shape, a pyramidal shape, and a multi-arm shape, or may be cubic nanoparticles, nanotubes, nanowires, nanofibers, nano-platelets, or the like.

In another exemplary embodiment, each of the first wavelength-converting material WC1a and the second wavelength-converting material WC2a may include, phosphor, quantum rods, or phosphor materials, as well as quantum dots. In an exemplary embodiment, the phosphor may have a size of approximately 100 to 3,000 nm. Further, the phosphor may include yellow, green, and red fluorescent materials.

More particularly, the first and second wavelength-converting materials WC1a and WC2a absorb the light supplied to the first wavelength conversion layer WC1 and the second wavelength conversion layer WC2, respectively, to emit light having a central wavelength different that of the absorbed light. More specifically, the first and second wavelength-converting materials WC1a and WC2a may scatter the light incident on the first wavelength conversion layer WC1 and the second wavelength conversion layer WC2, respectively, to emit light in different directions regardless of the incident angles. In this manner, the display device according to an exemplary embodiment of the invention may improve the viewing angle by emitting light in various directions through the first and second wavelength-converting materials WC1a and WC2a. Light emitted from the first wavelength conversion layer WC1 and the second wavelength conversion layer WC2 may be un-polarized.

A second filter 250 is disposed on the surface of each of the first wavelength conversion layer WC1, the second wavelength conversion layer WC2, and the first transmission layer 241 that faces the lower substrate 110. In an exemplary embodiment, the second filter 250 may transmit the light having the first wavelength range, and may reflect the light having the second wavelength range and the light having the third wavelength range. In particular, the second filter 250 may transmit blue light and reflect red light and green light. In this manner, the second filter 250 may improve the emission efficiency of the light emitted from the first wavelength conversion layer WC1 or the second wavelength conversion layer WC2. In an exemplary embodiment, the second filter 250 may surround the first wavelength conversion layer WC1, the second wavelength conversion layer WC2, and the transmission layer 240.

For example, a portion of the second filter 250 that surrounds the first wavelength conversion layer WC1 may transmit blue light, which is then provided to the first wavelength conversion layer WC1. The blue light supplied to the first wavelength conversion layer WC1 is converted into red light by the first wavelength-converting material WCla, so that the light exits toward the upper substrate 210 (e.g., to the outside). On the other hand, among the converted red light, light directed toward the lower substrate 110 rather than toward the upper substrate 210 may be reflected by a part of the second filter 250 surrounding the first wavelength conversion layer WC1.

The second filter 250 may have a single layer or multiple layer structure. When the second filter 250 is formed of multiple layers, the second filter 250 may include a layer including SiNₓ and a layer including SiOₓ. In an exemplary embodiment, the layers including SiNₓ and SiOₓ may be alternately stacked.

In addition, the display device according to an exemplary embodiment of the invention includes the first filter 220 and the second filter 250 to prevent color mixing. In addition, the display device according to an exemplary embodiment of the invention may improve color gamut by improving the emission efficiency of the light exiting from the first wavelength conversion layer WC1 or the second wavelength conversion layer WC2.

A planarization layer 260 is disposed on the surface of the second filter 250 facing the lower substrate 110. In an exemplary embodiment, the planarization layer 260 may include an organic material. When the first wavelength conversion layer WC1, the second wavelength conversion layer WC2, and the transmission layer 240 have different thicknesses, the planarization layer 260 may substantially flatten the levels of the elements stacked on a surface of the upper substrate 210.

A third insulating layer 270 is disposed on the surface of the planarization layer 260 facing the lower substrate 110. In an exemplary embodiment, the third insulating layer 270 may include an inorganic insulative material, such as silicon nitride and silicon oxide. According to an exemplary embodiment, the third insulating layer 270 may be omitted.

A second polarizing layer 280 may be disposed on the surface of the third insulating layer 270 facing the lower substrate 110. In an exemplary embodiment, the second polarizing layer 280 may include a conductive material that allows electric current to flow. In an exemplary embodiment, the conductive material may include a metal including aluminum (Al), silver (Ag), gold (Au), copper (Cu), and nickel (Ni). In addition, the conductive material may further include titanium (Ti) and molybdenum (Mo).

In an exemplary embodiment, the second polarizing layer 280 may be a wire grid polarizer. Accordingly, the second polarizing layer 280 may include a pattern of plurality of line gratings 281 protruding toward the lower substrate 110. In an exemplary embodiment, the second polarizing layer 280 may include aluminum, silver, copper, nickel, etc.

For example, after the incident light passes through the second polarizing layer 280, components in parallel with the second polarizing layer 280 may be absorbed or reflected, while only vertical components may be transmitted, such that light may be polarized. In an exemplary embodiment, the second polarizing layer 280 may be formed by nanoimprinting or the like.

The second polarizing layer 280 may further include a capping layer 282. The capping layer 282 can suppress defects, such as corrosion of the second polarizing layer 280, and can provide a flat surface over the second polarizing layer 280.

A common electrode CE may be disposed on the surface of the second polarizing layer 280 facing the lower substrate 110. The common electrode CE may overlap with at least a part of each of the first to third pixel electrodes PE1 to PE3. In an exemplary embodiment, the common electrode CE may be a single, continuous electrode. In an exemplary embodiment, the common electrode CE may include a transparent conductive material, such as ITO and IZO, or a reflective metal, such as aluminum, silver, chrome, or an alloy thereof.

Hereinafter, the liquid-crystal layer 300 will be described.

The liquid-crystal layer 300 may include liquid-crystal molecules LC. In an exemplary embodiment, the liquid-crystal molecules LC may have negative dielectric anisotropy. When no electric field is applied to the liquid-crystal layer 300, the liquid-crystal molecules LC 31 may be orientated in a direction perpendicular to the lower substrate 110. When an electric field is formed between the lower substrate 110 and the upper substrate 210, the liquid-crystal molecules LC may be rotated or tilted in a particular direction, which may change the polarization of light supplied to the liquid-crystal layer 300. In an exemplary embodiment, the liquid-crystal molecules LC may have positive dielectric anisotropy.

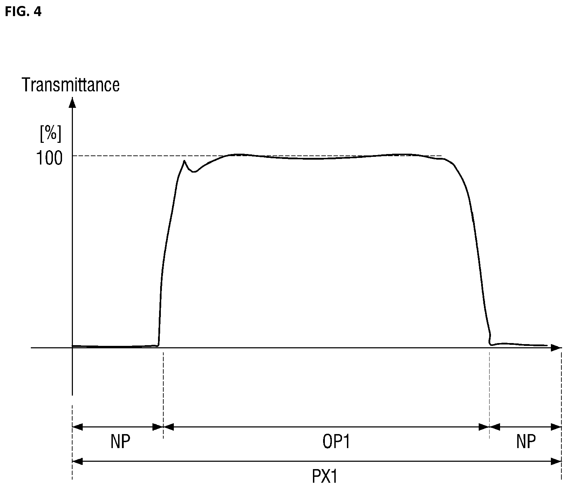

FIG. 4 is a graph illustrating transmittance measured over different areas of a first pixel according to an exemplary embodiment of the invention.

FIG. 4 shows the transmittance measured over different positions of the first pixel PX1 according to the exemplary embodiment shown in FIG. 1, which is measured along the first direction dr1 so as to pass through the first open area OP1 as depicted in FIG. 1. The x-axis of the graph denotes the positions on the first pixel PX1, and the y-axis of the graph denotes the transmittance. The transmittance is expressed as a percentage (%). The transmittance is 100% at the position having the maximum value.

Referring to FIG. 4, the transmittance at the light-blocking area NP of the first pixel PX1 is substantially 0%. In the light-blocking area NP, the light is blocked by the first light-blocking element BM1, and thus the transmittance may be substantially equal to 0%.

In the first open area OP1, the transmittance is uniformly maintained close to 100% throughout the area. More particularly, in the first open area OP1, no dark portion where the transmittance falls below 50% may be recognized. Even if there is a collision of the liquid-crystal molecules LC that forms a dark portion, the collision is guided into the first groove GV1, and thus, the dark portion may not be recognized from the first open area OP1.

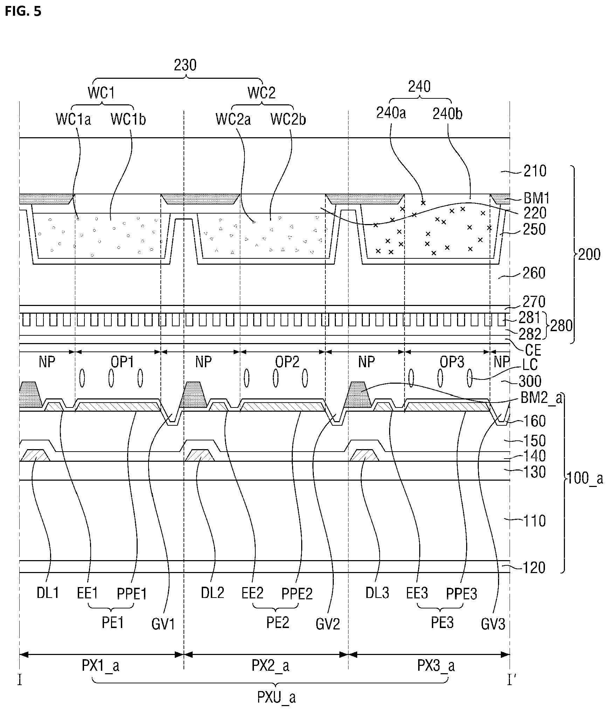

FIG. 5 is a cross-sectional view of a pixel unit according to this exemplary embodiment of the invention, taken along line I - I' of FIG. 1. The same elements already described above with respect to FIGS. 1 and 2 will not be described again to avoid redundancy.

Referring to FIG. 5, a pixel unit PXU_a according to the present exemplary embodiment may include a bottom panel 100_a, a top panel 200, and a liquid-crystal layer 300, and may be divided into first to third pixels PX1_a to PX3_a.

The bottom panel 100_a includes a lower substrate 110, a first polarizing layer 120, a first insulating layer 130, a passivation layer 140, a second insulating layer 150, first to third pixel electrodes PE1 to PE3, an alignment layer 160, and a second light-blocking element BM2_a.

The second light-blocking element BM2_a is disposed on the alignment layer 160. The second light-blocking element BM2_a may include a material that blocks light, similarly to the first light-blocking element BM1. For example, the second light-blocking element BM2_a may include an organic material or a metallic material including chromium.

The second light-blocking element BM2_a may prevent color mixing among the first pixel PX1_a, the second pixel PX2_a, and the third pixel PX3_a. For example, light that is converted by the first wavelength conversion layer WC1 to have the second wavelength range may include a component that travels toward the liquid-crystal layer 300, in addition to a component that travels toward the upper substrate 210. Among these components, light having the second wavelength range that travels toward the liquid-crystal layer 300 may be reflected again by the elements of the bottom panel 100_a and the liquid-crystal layer 300, and then travels toward the upper substrate 210. However, some of the light may travel toward the second open area OP2 instead of the first open area OP1. As such, the second light-blocking element BM2_a may block the light traveling toward the second open area OP2 to prevent color mixing.

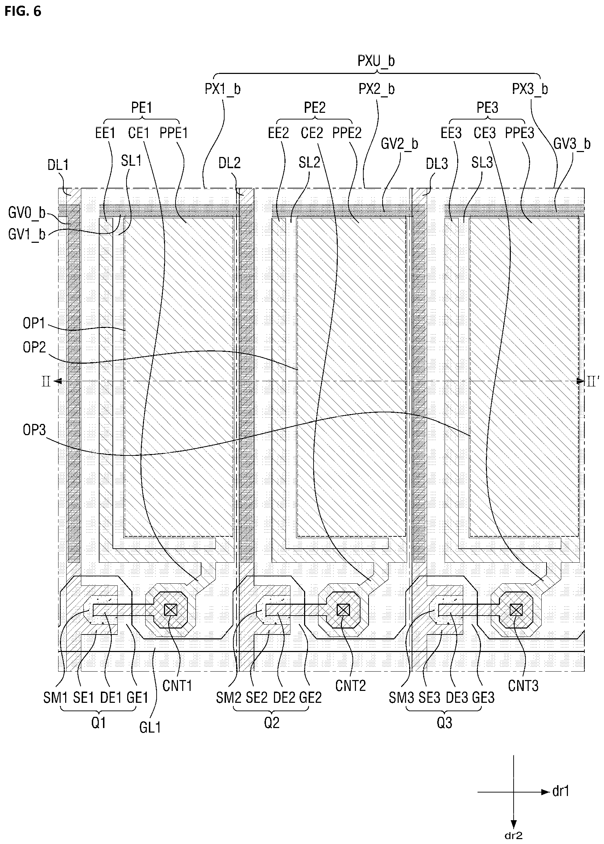

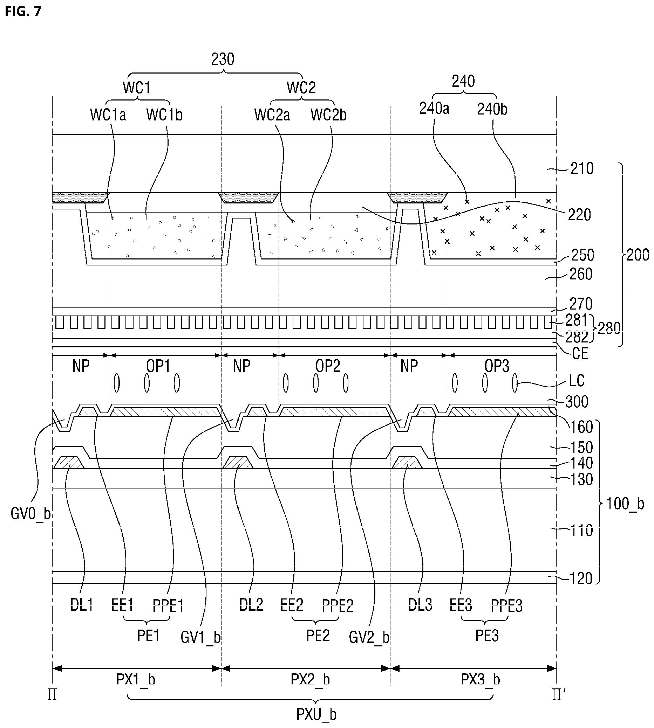

FIG. 6 is a layout diagram showing a pixel unit according to another exemplary embodiment of the invention. FIG. 7 is a cross-sectional view taken along line II - II' of FIG. 6. The same elements already described above with respect to FIGS. 1 and 2 will not be described again to avoid redundancy.

Referring to FIGS. 6 and 7, a pixel unit PXU_b according to this exemplary embodiment includes first to third pixels PX1_b to PX3_b.

The first to third pixels PX1_b to PX3_b include first to third pixel electrodes PE1 to PE3, respectively. The first to third pixel electrodes PE1 to PE3 include first to third planar electrodes PPE1 to PPE3, first to third edge electrodes EE1 to EE3, and first to third connecting electrodes CE1 to CE3, respectively. In addition, the first to third pixels PX1_b to PX3_b include first to third grooves GV1_b to GV3_b, respectively.

In this exemplary embodiment, a part of the first groove GV1_b may be disposed to overlap with the second data line DL2 disposed in the second pixel PX2_b. More specifically, a portion of the first groove GV1_b that extends along the second direction dr2, which is the same direction as the direction to which the second data line DL2 extends, may be disposed to overlap with the second data line DL2.

Likewise, a portion of the second groove GV2_b that extends along the second direction dr2 may be disposed to overlap with the third data line DL3. The first data line DL1 may be disposed to overlap with a portion of a groove GV0_b of a pixel disposed adjacent to the left side of the first pixel PX1_b.

By virtue of this structure, the area of the first open area OP1, the second open area OP2, and the third open area OP3, and the area of the first to third planar electrodes PPE1 to PPE3 may be increased, which may improve the transmittance.

More specifically, the liquid-crystal molecules LC adjacent to the first to third groove patterns GV1_b to GV3_b are tilted to converge on the first to third groove patterns GV1_b to GV3_b, which may generate a dark portion in the first to third groove patterns GV1_b to GV3_b. As such, the first to third groove patterns GV1_b to GV3_b are overlapped by the first light-blocking element BM1. Further, since the first to third data lines DL1 to DL3 may also reflect light, they are overlapped by the first light-blocking element BM1 as well. Since the first to third grooves GV1_b to GV3_b and the first to third data lines DL1 to DL3 are all overlapped by the first light blocking member BM1, by forming portions of the first to third grooves GV1_b to GV3_b, GV3_b and the first to third data lines DL1 to DL3 to overlap each other, the area occupied by the first light-blocking element BM1 may be reduced. Accordingly, the area of the first to third open areas OP1 to OP3 and the area of the first to third planar electrodes PPE1 to PPE3 may also be increased, which may improve the transmittance.

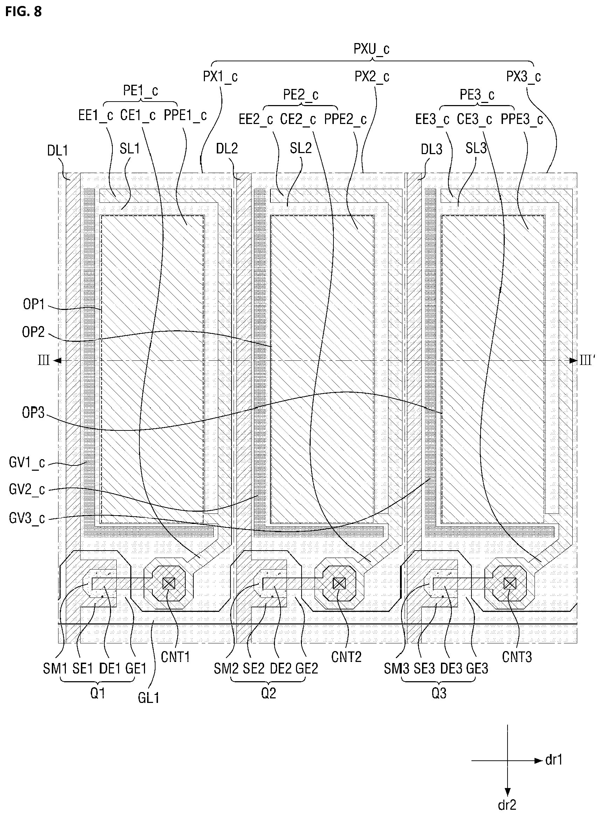

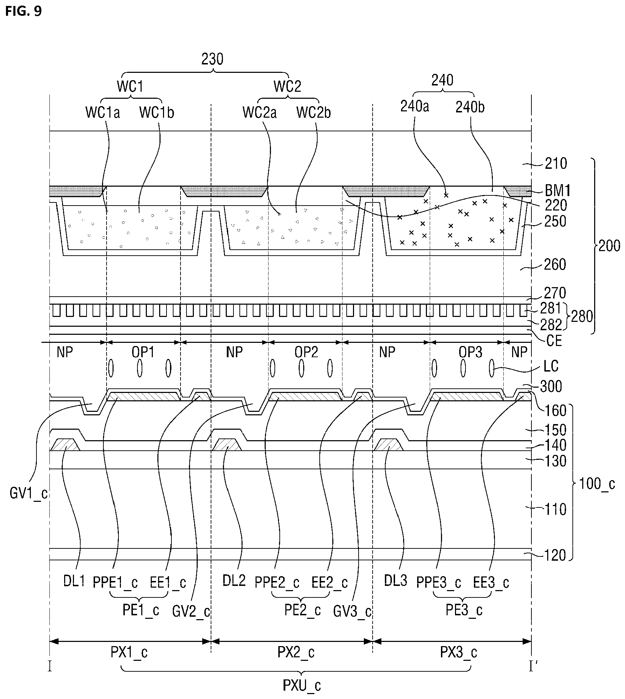

FIG. 8 is a layout diagram showing a pixel unit according to another exemplary embodiment of the invention. FIG. 9 is a cross-sectional view taken along line III - III' of FIG. 8. The same elements already described above with respect to FIGS. 1 and 2 will not be described again to avoid redundancy.

Referring to FIGS. 8 and 9, a pixel unit PXU_c according to this exemplary embodiment includes first to third pixels PX1_c to PX3_c.

The first to third pixels PX1_c to PX3_c include first to third pixel electrodes PE1_c to PE3_c, respectively. The first to third pixel electrodes PE1_c to PE3_c include first to third planar electrodes PPE1_c to PPE3_c, first to third edge electrodes EE1 to EE3, and first to third connecting electrodes CE1_c to CE3_c, respectively. In addition, the first to third pixels PX1_c to PX3_c include first to third grooves GV1_c to GV3_c, respectively.

According to this exemplary embodiment, the first to third edge electrodes EE1_c to EE3_c may be disposed adjacent to the right side and the upper side of the first to third open areas OP1 to OP3, respectively. Further, the first to third grooves GV1_c to GV3_c may be disposed adjacent to the left side and the lower side of the first to third open areas OP1 to OP3, respectively. Accordingly, the liquid-crystal molecules LC may be controlled so that they are tilted in a diagonal direction from the right upper end to the left lower end of FIG. 8. In addition, the alignment direction of the alignment layer 160 may also be a diagonal direction from the right upper end to the left lower end of FIG. 8.

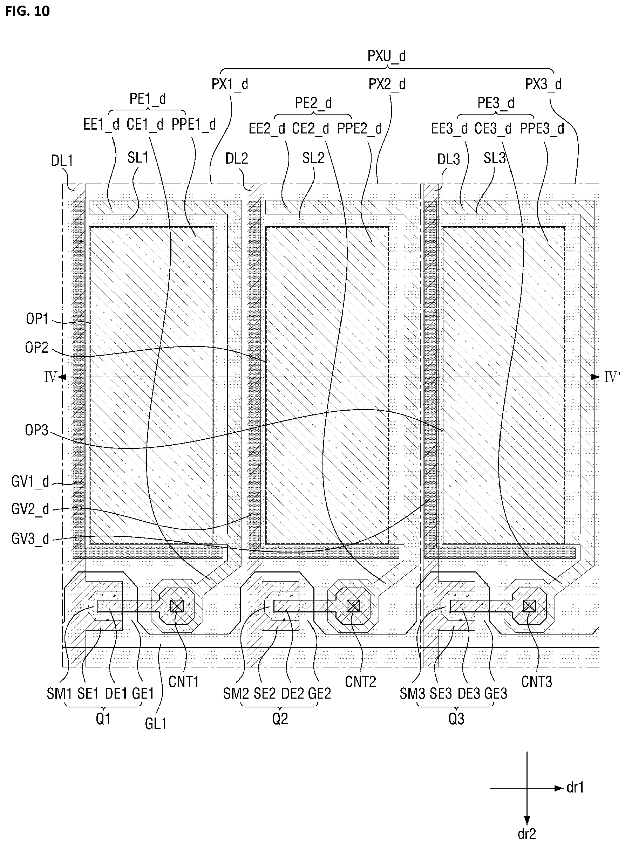

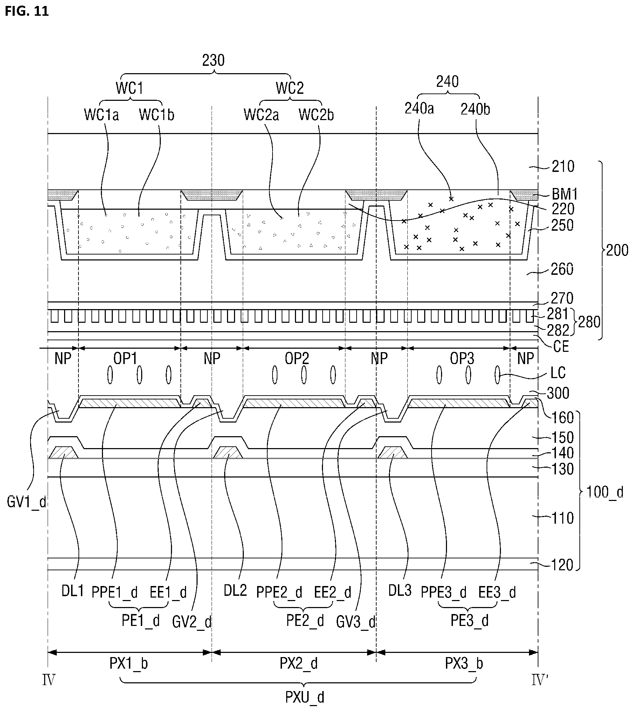

FIG. 10 is a layout diagram showing a pixel unit according to another exemplary embodiment of the invention. FIG. 11 is a cross-sectional view taken along line IV - IV' of FIG. 10. The same elements already described above with respect to FIGS. 1, 2, 8, and 9 will not be described again to avoid redundancy.

Referring to FIGS. 10 and 11, a pixel unit PXU_d according to this exemplary embodiment includes first to third pixels PX1_d to PX3_d.

The first to third pixels PX1_d to PX3_d include first to third pixel electrodes PE1_d to PE3_d, respectively. The first to third pixel electrodes PE1_d to PE3_d include first to third planar electrodes PPE1_d to PPE3_d, first to third edge electrodes EE1_d to EE3_d, and first to third connecting electrodes CE1_d to CE3_d, respectively. In addition, the first to third pixels PX1_d to PX3_d include first to third grooves GV1_d to GV3_d, respectively.

According to the this exemplary embodiment, the first to third edge electrodes EE1_d to EE3_d may be disposed adjacent to the right side and the upper side of the first to third open areas OP1 to OP3, respectively, similar to the exemplary embodiment shown in FIGS. 8 and 9. Further, the first to third grooves GV1_d to GV3_d may be disposed adjacent to the left side and the lower side of the first to third open areas OP1 to OP3, respectively. Accordingly, the liquid-crystal molecules LC may be controlled so that they are tilted in a direction from the right upper end to the left lower end of FIG. 10. In addition, the alignment direction of the alignment layer 160 may also be a direction from the right upper end to the left lower end of FIG. 10.

In addition, a portion of the first groove GV1_d that extends along the second direction dr2 may be disposed to overlap with the first data line DL1. Likewise, a portion of the second groove GV2_d that extends along the second direction dr2 may be disposed to overlap with the second data line DL2. In addition, a portion of the third groove GV3_d that extends along the second direction dr2 may be disposed to overlap with the third data line DL3.

By virtue of this structure, the area of the first open area OP1, the second open area OP2 and the third open area OP3, and the area of the first to third planar electrodes PPE1_d to PPE3_d may be increased, which may improve light transmittance.

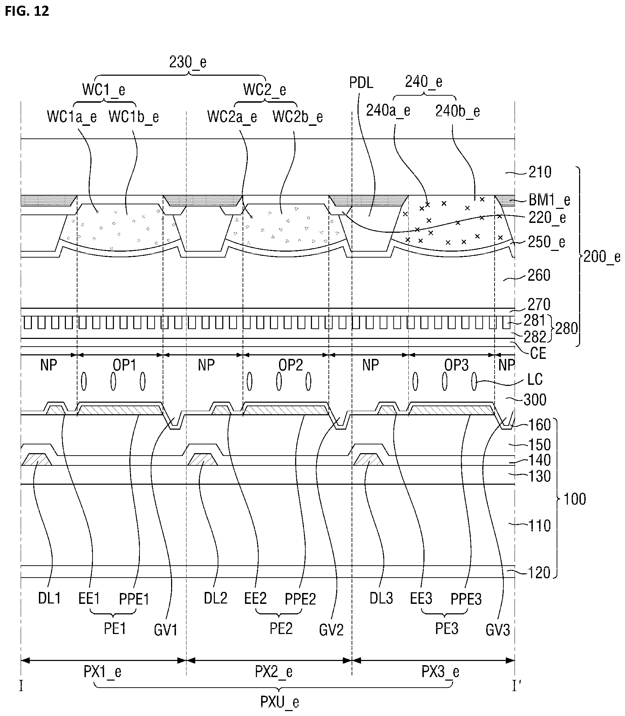

FIG. 12 is a cross-sectional view of a pixel unit according to another exemplary embodiment of the invention, taken along line I - I' of FIG. 1.

The same elements already described above with respect to FIGS. 1 and 2 will not be described again to avoid redundancy.

Referring to FIG. 12, a display device according to this exemplary embodiment includes a bottom panel 100, a top panel 200_e, and a liquid-crystal layer 300. Further, the display device includes a plurality of pixel units PXU_e arranged in a matrix.

The bottom panel 100 and the liquid-crystal layer 300 are identical to those described above with reference to FIGS. 1 and 2, and, therefore, the redundant description will be omitted. The top panel 200_e may face the lower substrate 110.

A first light-blocking element BM1_e may be disposed on a surface of the upper substrate 210 facing the lower substrate 110. A first filter 220 is disposed on a surface of the first light-blocking element BM1_e facing the lower substrate 110. Description of the first light-blocking element BM1_e and the first filter 220 will be omitted to avoid redundancy.

A pixel-defining layer PDL is disposed on a surface of the first light-blocking element BM1_e and a surface of the first filter 220, which face the lower substrate 110. The pixel-defining layer PDL may be disposed to at least partially expose the surface of the upper substrate 210. More particularly, the pixel-defining layer PDL may have an opening exposing at least a part of the surface of the upper substrate 210.

The pixel-defining layer PDL may be disposed in each pixel unit PXU_e, such that it does not overlap with the first to third open areas OP1, OP2 and OP3. The pixel-defining layer PDL may have a lattice structure when viewed from below the surface of the upper substrate 210 facing the lower substrate 110.

Accordingly, when a color conversion layer 230_e and a transmission layer 240_e are formed through an inkjet process, the pixel-defining layer PDL may make the process of aligning the ejected ink composition easier. For example, the pixel-defining layer PDL may work as a guide for accurately ejecting and stably positioning the ink composition for forming the color conversion layer 230_e and the transmission layer 240_e at a desired position. In particular, the pixel-defining layer PDL may facilitate formation of the color conversion layer 230_e and the transmission layer 240_e.

The color conversion layer 230_e and the transmission layer 240_e are disposed in the spaces surrounded by the pixel-defining layer PDL. A second filter 250_e is disposed on a surface of the pixel-defining layer PDL, a surface of the color conversion layer 230_e, and a surface of the transmission layer 240_e that face the lower substrate 110.

A planarization layer 260 is disposed on the surface of the second filter 250_e facing the lower substrate 110. A common electrode CE is disposed on the surface of the second polarizing layer 280 facing the lower substrate 110. Accordingly, according to this exemplary embodiment, an inkjet process may be employed to form the upper substrate 210.

As discussed, embodiments of the invention can provide a liquid-crystal display, (LCD,) device comprising: a first substrate having a plurality of pixels defined thereon; an insulating layer disposed on the first substrate; a pixel electrode disposed on the insulating layer in each of the pixels; an alignment layer disposed on the pixel electrode; a second substrate facing the first substrate; a wavelength conversion layer and a transmission layer disposed on the second substrate to face the first substrate; a common electrode interposed between the first substrate and disposed on the wavelength conversion layer and the transmission layer; and a liquid-crystal layer interposed between the alignment layer and the common electrode, wherein: each of the pixels comprises an open area including at least one first side and that at least partially overlaps with one of the wavelength conversion layer and the transmission layer; and the insulating layer comprises a pattern of grooves disposed adjacent to the at least one first side of the open area.

In some embodiments, the LCD device may further comprise a light-blocking member disposed between the common electrode and the second substrate, wherein the light-blocking member comprises a plurality of openings; wherein the open area of a pixel corresponds to an opening of in the light-blocking member; and wherein each pixel further comprises a pixel overlap region outside the opening region.

In some embodiments, the pattern of grooves overlaps the light-blocking member in the pixel overlap region.

In some embodiments, the light-blocking member is disposed on the second substrate to face the first substrate, wherein the pattern of grooves overlaps the light-blocking member.

In some embodiments, the wavelength conversion layer comprises: a first wavelength conversion layer configured to convert light of a first wavelength region into light of a second wavelength region different from the first wavelength region; and a second wavelength conversion layer configured to convert light of the first wavelength region into light of a third wavelength region different from the first wavelength region and the second wavelength region. The transmission layer may be configured to transmit light.

In some embodiments, the first wavelength conversion layer corresponds to a first pixel, the second wavelength conversion layer is adjacent the first wavelength conversion layer and corresponds to a second pixel, and the transmission layer is adjacent the second wavelength conversion layer and corresponds to a third pixel.

Although certain exemplary embodiments and implementations have been described herein, other embodiments and modifications will be apparent from this description. Accordingly, the inventive concepts are not limited to such embodiments, but rather to the broader scope of the appended claims and various obvious modifications and equivalent arrangements as would be apparent to a person of ordinary skill in the art.

## Claims

1. A liquid-crystal display, LCD, device comprising:
a first substrate having a plurality of pixels defined thereon;
an insulating layer disposed over the first substrate;
a pixel electrode disposed over the insulating layer in each of the pixels;
an alignment layer disposed over the pixel electrode;
a second substrate facing the first substrate;
a wavelength conversion layer and a transmission layer disposed on the second substrate to face the first substrate;
a common electrode interposed between the first substrate and the wavelength conversion layer and the transmission layer; and
a liquid-crystal layer interposed between the alignment layer and the common electrode,
wherein:
each of the pixels comprises an open area including at least one first side and that at least partially overlaps with one of the wavelength conversion layer and the transmission layer; and
the insulating layer comprises a pattern of grooves disposed adjacent to the at least one first side of the open area.

2. The LCD device of claim 1, further comprising a light-blocking member disposed between the common electrode and the second substrate, wherein the light-blocking member comprises a plurality of openings;
wherein the open area of a pixel corresponds to an opening of in the light-blocking member; and wherein each pixel further comprises a pixel overlap region outside the opening region.

3. The LCD device of claim 2, wherein the pattern of grooves overlaps the light-blocking member in the pixel overlap region.

4. The LCD device of any one of claims 1 to 3, wherein the wavelength conversion layer comprises:
a first wavelength conversion layer configured to convert light of a first wavelength region into light of a second wavelength region different from the first wavelength region; and
a second wavelength conversion layer configured to convert light of the first wavelength region into light of a third wavelength region different from the first wavelength region and the second wavelength region;
optionally wherein the transmission layer is configured to transmit light.

5. The LCD device of claim 4, wherein the first wavelength conversion layer corresponds to a first pixel, the second wavelength conversion layer is adjacent the first wavelength conversion layer and corresponds to a second pixel, and the transmission layer is adjacent the second wavelength conversion layer and corresponds to a third pixel.

6. The LCD device of any one of claims 1 to 5, wherein the pixel electrode comprises:
a planar electrode disposed adjacent to one of the grooves; and
an edge electrode disposed adjacent to at least a second side of the open area, the edge electrode having a shape that substantially conforms to the at least one first side of the open area.

7. The LCD device of claim 6, wherein:
the planar electrode and the edge electrode is spaced apart from each other by a slit therebetween; and the slit has a shape substantially conforming to opposing sides of the planar electrode and the edge electrode;
optionally wherein a width of the slit is substantially uniform over its length.

8. The LCD device of claim 6 or 7, wherein:
the first side of the open area faces the second side of the open area; and the planar electrode is interposed between the first side and the second side of the open area;
optionally wherein the alignment layer is orientated in a direction from one end of the first side of the open area toward one end of the second side of the open area.

9. The LCD device of any one of claims 6 to 8, wherein the groove is formed on the first or second sides of the open area.

10. The LCD device of any one of claims 6 to 9, wherein the edge electrode is disposed adjacent to the second side of the open area.

11. The LCD device of any one of claims 6 to 10, wherein the planar electrode overlaps with the open area.

12. The LCD device of claim 2 or any claim when dependent on claim 2, wherein the light-blocking member is disposed on the second substrate to face the first substrate,
wherein the pattern of grooves overlaps the light-blocking member.

13. The LCD device of any one of claims 1 to 12, wherein a width of the groove is equal to or greater than 1 µm; and/or
wherein a depth of the groove is equal to or greater than 1 µm; and/or
wherein the insulating layer has a refractive index of 1.5 or less.

14. The LCD device of any one of claims 1 to 13, wherein the wavelength conversion layer comprises at least one of quantum dots and a phosphor material.

15. The LCD device of any one of claims 1 to 14, further comprising a plurality of data lines disposed between the first substrate and the insulating layer, at least some of the data lines are disposed between the open area and adjacent open area,
wherein a portion of at least one of the grooves overlaps the data line.
